# EUROPEAN PATENT APPLICATION

(11) **EP 2 131 399 A2**
(43) Date of publication of application: **09.12.2009**
(21) Application number: 09006857.8
(22) Date of filing: 20.05.2009
(51) Int. Cl.: H01L 29/78, H01L 29/423, H01L 27/088, H01L 21/336, H01L 21/8234

(54) **Insulated gate semiconductor device and method of manufacturing the same**

(30) Priority: 23.05.2008 JP 2008135897
(71) Applicant: NEC Electronics Corporation, Kawasaki, Kanagawa 211-8668 (JP)
(72) Inventor: Mori, Takahiro, Kawasaki Kanagawa 211-8668 (JP)
(74) Representative: Glawe, Delfs, Moll

(57) **Abstract**

A semiconductor device in a semiconductor substrate (10) including a first region (12), a source region (20), a second region (14), a drain region (30), a gate insulating layer (60), a field insulating layer (50) and a gate electrode (40). The field insulating layer has, in its portion overlapping the gate electrode, such a step (51) that a portion of the field insulating layer between the step and the gate insulating layer is thinner than the rest of the field insulating layer.

## Description

### Background of the invention

### 1. Field of the Invention

The present invention relates to a semiconductor device and a method of manufacturing the same. Particularly, the present invention relates to a high breakdown-voltage semiconductor device having a field drain structure and a method of manufacturing the same.

### 2. Description of the Related Art

There has been known a high breakdown-voltage semiconductor device having a field drain structure. As an example of the semiconductor device, a transistor is described in Background Art in Japanese Patent Application Publication 2005-183633. FIG. 1 is a cross-sectional view showing a high breakdown-voltage transistor having a typical field drain structure. In this transistor, a source region 140 of a second conductivity type, a region 120 of a first conductivity type which surrounds the source region 140, a high-concent ration drain region 160 of the second conductivity type, and a low-concentration field region 150 of the second conductivity type which surrounds the drain region 160 are formed in the front surface of a semiconductor substrate 110. The front surface of a region 125 of the first conductivity type (including the region 120 and the semiconductor substrate 110) located between the source region 140 and the field region 150 of the second conductivity type are covered with a thin gate insulating layer 175. The front surface of the field region 150 of the second conductivity type is covered with an insulating separation layer 170. The insulating separation layer 170 becomes progressively thicker (corresponding to a portion 170a) toward the drain region 160 from a vicinity of a boundary between the region 125 of the first conductivity type and the field region 150 of the second conductivity type. A gate electrode 180 is provided in a way that a part of the gate insulating layer 175 and a part of the insulating separation layer 170 are covered with the gate electrode 180.

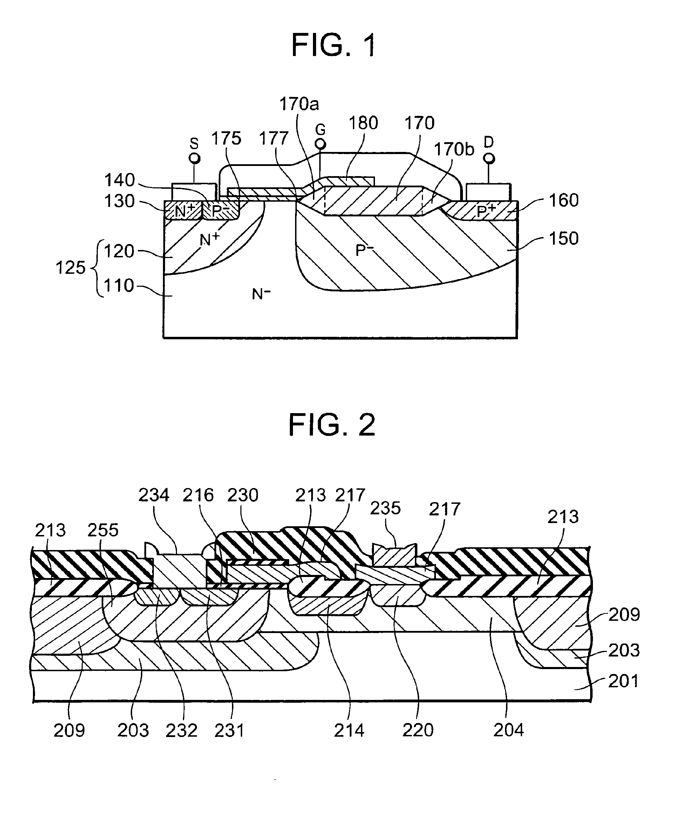

Generally speaking, a breakdown voltage (BVds) of a transistor having a field drain structure depends on: the location of a gate electrode (corresponding to the gate electrode 180 in FIG. 1) overlapping a field oxide film (corresponding to the insulating separation layer 170 in FIG. 1); the concentration of an offset layer (corresponding to the field region 150 in FIG. 1) ; and the film thickness of the field oxide film (corresponding to the insulating separation layer 170 in FIG. 1) ; and the like. Note that the semiconductor device disclosed in Japanese Patent Application Publication No. 2005-183633 has the configuration shown in FIG. 1, in which the thickness of the insulating separation layer 170 is at least locally reduced in a range between the drain region 160 and a location where the thickness of the insulating separation layer 170 reaches a predetermined thickness (in a thicker portion sandwiched between the portion 170a and a portion 170b).

Japanese Patent Application Publication No. Hei. 11-317519 discloses a semiconductor device and a method of manufacturing the same. FIG. 2 is a cross-sectional view of the semiconductor device disclosed in Japanese Patent Application Publication No. Hei. 11-317519. This semiconductor device includes at least: a semiconductor substrate 201 of a first conductivity type; a semiconductor layer 204 of a second conductivity type which is formed on the semiconductor substrate 201 of the first conductivity type; an insulating film 216 which is formed on the semiconductor layer 204 of the second conductivity type; an impurity diffusion layer 225 of the first conductivity type which is formed in a surface area of the semiconductor layer 204 of the second conductivity type; a source region 231 of the second conductivity type which is formed in a surface area of the impurity diffusion layer 225 of the first conductivity type; a drain region 220 of the second conductivity type which is formed in a surface area of the semiconductor layer 204 of the second conductivity type with a predetermined clearance between the drain region 220 of the second conductivity type and the impurity diffusion layer 225 of the first conductivity type; an element separation layer 213 which is formed in a surface area of the semiconductor layer 204 of the second conductivity type between the source region 231 of the second conductivity type and the drain region 220 of the second conductivity type, the element separation layer 213 being made of an insulating material; and a gate electrode 217 which is formed above the source region 231 of the second conductivity type, the impurity diffusion layer 225 of the first conductivity type and the element separation layer. 213 with an insulating film 216 being interposed between the gate electrode 217 and the source region 231 of the second conductivity type as well as between the gate electrode 217 and the impurity diffusion layer 225 of the first conductivity type, the gate electrode 217 being made of a polysilicon. The element separation layer 213 includes a first surface and a second surface which is located lower than the first surface. The first surface is arranged close to the source region 231 of the second conductivity type, and the second surface is arranged close to the drain region 220 of the second conductivity type. The gate electrode 217 is formed in a way that the first surface and the second surface are continuously covered with the gate electrode 217.

In this semiconductor device, specifically, a portion of the element separation layer 213 which is located in a vicinity of the drain region 220 is formed thinner than the rest of the element separation layer 213. In addition, the gate electrode 217 continuously covers a thicker portion (a portion on a side closer to the source region 231) and the thinner portion (the portion on a side closer to the drain region 220) of the element separation layer 213. A portion of the element separation layer 213 which is located in a vicinity of a bonding interface between the impurity diffusion layer 225 (a P well) of the first conductivity type and an N type drift region 214 is formed thicker. In this respect, Japanese Patent Application Publication No. Hei. 11-317519 describes that an apparent bonding concentration between the impurity diffusion layer 225 (the P well) of the first conductivity type and the N type drift region 214 does not increase so that a breakdown voltage of the transistor while the transistor is ON is prevented from decreasing. Moreover, Japanese Patent Application Publication No. Hei. 11-317519 describes that, because the portion of the element separation layer 213 which is located in the vicinity of the drain region 220 is formed thinner, the formation of an accumulation layer is actively facilitated on a front surface of the drift region 220 so that the on-resistance of the transistor can be reduced.

### SUMMARY OF THE INVENTION

In a transistor having a typical field drain structure as shown in FIG. 1, the breakdown voltage BVds is determined by one of : an edge of a field oxide film (the insulating separation layer 170) ; an edge of a gate electrode (the gate electrode 180) located on the field oxide film (the insulating separation layer 170); and a vicinity of a drain high-concentration layer (the high-concentration drain region160). In order to increase BVds, the field oxide film (the insulating separation layer 170) should desirably be formed thicker. However, such formation increases the on-resistance. Meanwhile, in the case of transistor having the structure in which, as shown in FIG. 2, a portion of a field oxide film (the insulating separation layer 170) on a side closer to a drain region is formed thinner whereas a portion of the field oxide film on a side closer to a source region is formed thicker, itmaybepossibletoreducetheon-resistance. However, it is considered difficult to increase BVds while the transistor is OFF, because the field oxide film (the insulating separation layer 213) under an edge of the gate electrode (the gate electrode 217) is formed thin. Thus, a semiconductor device capable of simultaneously increasing the breakdown voltage (BVds) and reducing the on-resistance are desired.

Hereinbelow, descriptions will be provided for means for solving the problem by use of reference numerals and letters used to describe the preferred embodiments of the present invention. These reference numerals and letters are added to components of the semiconductor device according to the present invention with parentheses being put around each of the reference numerals and letters in order to clarify the corresponding relationship between the descriptions in the scope of claims and the preferred embodiments of the present invention. However, neither reference numerals nor letters shall be used to interpret the technical scope of the present invention which is described in the scope of claims.

The semiconductor device according to the present invention includes a first region (12), a source region (20), a second region (14), a drain region (30), a gate insulating layer (60), a field insulating layer (50) and a gate electrode (40). The first region (12) is formed in a surface area of a semiconductor substrate (10), and is of a first (P) conductivity type. The source region (20) is formed on a surface area of the first region (12), and is of a second (N) conductivity type. The second region (14) is formed in a surface area of the semiconductor substrate (10), and is of the second (N) conductivity type. The drain region (30) is formed in a surface area of the second region (14), and is of the second (N) conductivity type. The gate electrode (60) is formed on a front surface of the semiconductor substrate (10) between the source region (20) and the second region (14). The field insulating layer (50) is formed in a surface area of the semiconductor substrate (10) between the drain region (30) and the gate insulating layer (60). The gate electrode (40) covers a part of the gate insulating layer (60) and a part of the field insulating layer (50). The field insulating layer (50) has, in its portion overlapping the gate electrode (40), such a step (51) that a portion of the field insulating layer (50) between the step and the gate insulating layer (60) is thinner than the rest of the field insulating layer (50).

The present invention provides the step (51) to the portion of the field insulating layer (50) which overlaps the gate electrode (40), and accordingly makes a portion of the field insulating layer (50) on a side closer to the gate insulating layer (60) relatively thinner than the rest of the field insulating layer (50). Accordingly, a portion of the field insulating layer (50) which is located under an end portion of the gate electrode (40) on a side closer to the drain region (30) is thicker, and thereby the electric field can be attenuated, and the breakdown voltage can be increased. On the other hand, a portion of the field insulating layer (50) which is located under a portion of the gate electrode (40) between the gate insulating layer (60) and the step (51) is thinner, and thereby formation of an accumulation layer on the front surface of the field region (14) is facilitated, and the on-resistance is reduced at the same time. In short, the semiconductor device according to the present invention is capable of simultaneously increasing the breakdown voltage and reducing the on-resistance.

A method of manufacturing a semiconductor device according to the present invention includes the steps of: forming an insulating layer (60a) on a front surface of a semiconductor substrate (10), a second region (14) of a second (N) conductivity type in a surface area of the semiconductor substrate (10), and a field insulating layer (50) in a surface area of the second region (14); forming a resist film (92) having a pattern including an opening portion corresponding to a part of the field insulating layer (50); removing an upper portion of a part of the field insulating layer (50) by using the resist film (92) as a mask; forming a gate electrode (40) in a way that a part of a gate insulating layer (60) formed on the front surface of the semiconductor substrate (10) and a part of the field insulating layer (50) including a step (51) are covered with the gate electrode (40); forming a first region (12) of a first (P) conductivity type in a surface area of the semiconductor substrate (10); and forming a source region (20) of the second (N) conductivity type in a surface area of the first region (12), and a drain region (30) of the second (N) conductivity type in a surface area of the second region (14).

A semiconductor device manufactured in accordance with the present invention includes the step (51) in a portion of the field insulating layer (50) which overlaps the gate electrode (40). In addition, a portion of the field insulating layer (50) on the side closer to the gate insulating layer (60) is relatively thinner than the rest of the field insulating layer (50). For these reasons, like the foregoing semiconductor device, the semiconductor device manufactured according to the present invention is capable of simultaneously increasing the breakdown voltage and reducing the on-resistance.

Another method of manufacturing a semiconductor device according to the present invention includes a step of: forming a first insulating layer (60a) on a front surface of first formation section of a semiconductor substrate (10), and a second insulating layer (60a) on a front surface of a second formation section of the semiconductor substrate; a second region (14) of a second (N) conductivity type in a surface area of the first formation section, and a fourth region (14) of the second (N) conductivity type in a surface area of the first formation section; and a first field insulating layer (50a) in a surface area of the second region (14) and a second field insulating layer (50a) in a surface area of the fourth region (14). The method of manufacturing a semiconductor device according to the present invention also includes the steps of: forming a step by removing a part of the first insulating layer (60a) and an upper portion of a part of the first field insulating layer (50a) in the first formation section; forming, by thermal oxidation, a first gate insulating layer (60) on a front surface of the resultant first formation section, and a second gate insulating layer (60A) on a front surface of the resultant second formation section, the second gate insulating layer (60A) being obtained by thickening the second insulating layer (60a); forming a first gate electrode (40) in a way that a part of the first gate insulating layer (60) and a part of the first field insulating layer (50) including the step are covered with the first gate electrode (40), while forming a second gate electrode (40) in a way that a part of the second gate insulating layer (60A) and a part of the second field insulating layer (50A) are covered with the second gate electrode (40) ; forming a first region (12) of a first (P) conductivity type in a surface area of the consequent first formation section, and a third region (12) of the first (P) conductivity type in a surface area of the consequent second formation section; and forming a first source region (20) of the second (N) conductivity type in a surface area of the first region (12), and a first drain region (30) of the second (N) conductivity type in a surface area of the second region (14), while forming a second source region (20) of the second (N) conductivity type in a surface area of the third region (12), and a second drain region (30) of the second (N) conductivity type in a surface area of the fourth region (14).

The present invention is capable of simultaneously forming two types of transistors including the respective gate insulating layers (60, 60A) which are different in filmthickness. At least one of the two types of transistors includes the step (51) in the portion of the field insulating layer (50) which overlaps the gate electrode (40), and the portion of the field insulating layer (50) on the side closer to the gate insulating layer (60) is relatively thinner than the rest of the field insulating layer (50). For this reason, like the foregoing semiconductor device, this semiconductor device manufactured in accordance with the present invention is capable of simultaneously increasing the breakdown voltage and reducing the on-resistance.

The present invention is capable of providing a semiconductor device which is capable of simultaneously increasing the breakdown voltage (BVds) and reducing the on-resistance, and capable of providing a method for manufacturing the same.

### BRIEF DESCRIPTION OF THE DRAWINGS

FIG. 1 is a cross-sectional view showing a high breakdown-voltage transistor having a typical field drain structure.
FIG. 2 is a cross-sectional view showing a semiconductor device disclosed by Japanese Patent Application Publication No. Hei. 11-317519.
FIG. 3 is a cross-sectional view showing a configuration of a semiconductor device according to a first embodiment of the present invention.
FIG. 4 is a cross-sectional view showing an example of a method of manufacturing a semiconductor device according to the first embodiment of the present invention.
FIG. 5 is a cross-sectional view showing the example of the method of manufacturing a semiconductor device according to the first embodiment of the present invention.
FIG. 6 is a cross-sectional view showing the example of the method of manufacturing a semiconductor device according to the first embodiment of the present invention.
FIG. 7 is a cross-sectional view showing the example of the method of manufacturing a semiconductor device according to the first embodiment of the present invention.
FIG. 8 is a cross-sectional view showing the example of the method of manufacturing a semiconductor device according to the first embodiment of the present invention.
FIG. 9 is a cross-sectional view showing the example of the method of manufacturing a semiconductor device according to the first embodiment of the present invention.
FIG. 10 is a cross-sectional view showing the example of the method of manufacturing a semiconductor device according to the first embodiment of the present invention.
FIG. 11 is a cross-sectional view showing the example of the method of manufacturing a semiconductor device according to the first embodiment of the present invention.
FIG. 12 is a cross-sectional view showing the example of the method of manufacturing a semiconductor device according to the first embodiment of the present invention.
FIG. 13 is a cross-sectional view showing a configuration of a semiconductor device according to a second embodiment of the present invention.
FIG. 14 is a cross-sectional view showing an example of a method of manufacturing a semiconductor device according to the second embodiment of the present invention.
FIG. 15 is a cross-sectional view showing the example of the method of manufacturing a semiconductor device according to the second embodiment of the present invention.
FIG. 16 is a cross-sectional view showing the example of the method of manufacturing a semiconductor device according to the second embodiment of the present invention.
FIG. 17 is a cross-sectional view showing the example of the method of manufacturing a semiconductor device according to the second embodiment of the present invention.
FIG. 18 is a cross-sectional view showing the example of the method of manufacturing a semiconductor device according to the second embodiment of the present invention.
FIG. 19 is a cross-sectional view showing the example of the method of manufacturing a semiconductor device according to the second embodiment of the present invention.
FIG. 20 is a cross-sectional view showing the example of the method of manufacturing a semiconductor device according to the second embodiment of the present invention.

### DESCRIPTION OF THE PREFERRED EMBODIMENTS

Hereinbelow, descriptions will be provided for embodiments of a semiconductor device and a method of manufacturing the same of the present invention by referring to the attached drawings.

### (First Embodiment)

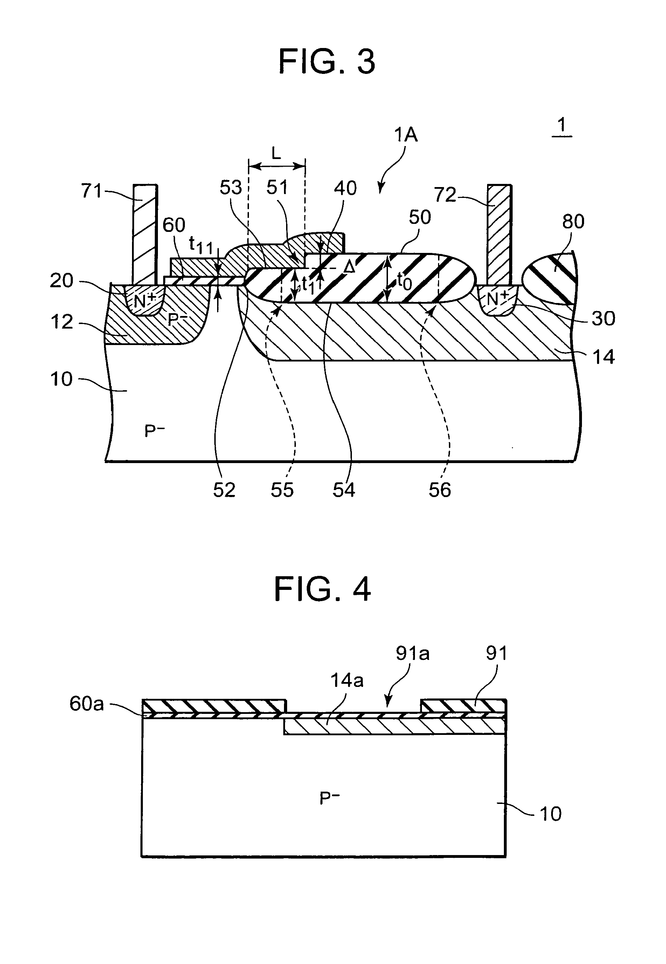

FIG. 3 is a cross-sectional view showing a configuration of a semiconductor device according to the present embodiment. This semiconductor device 1 includes: a P well 12 as a first region; a source region 20; a field region 14 as a second region; a drain region 30; a gate insulating layer 60; a field insulating layer 50; and a gate electrode 40.

The P well 12 is formed in a surface area of a P type semiconductor substrate 10 which a silicon substrate exemplifies. The conductivity type of the P well 12 is P type. The P type impurity concentration of the P well 12 is higher than that of the semiconductor substrate 10. The source region 20 is formed in a surface area of the semiconductor substrate 10 in the P well 12. The conductivity type of the source region 20 is N type. The source region 20 has an N type impurity concentration which is almost equal to that of the drain region 30. The source region 20 is connected to an upper interconnection via a contact 71.

The field region 14 is formed in a surface area of the semiconductor substrate 10. The conductivity type of the field region 14 is N type. The N type impurity concentration of the field region 14 is lower than that of the drain region 30. The drain region 30 is formed in a surface area of the semiconductor substrate 10 in the field region 14. The conductivity type of the drain region is N type. The drain region 30 is connected to an upper interconnection via a contact 72.

The gate insulating layer 60 is formed on a front surface of the semiconductor substrate 10 between the source region 20 and the field region 14. One end of the gate insulating layer 60 reaches a front surface of a part of the source region 20, and the other end of the gate insulating layer 60 reaches an end portion 52 of the field insulating layer 50. An oxide silicon layer exemplifies the gate insulating layer 60.

The field insulating layer 50 is formed between the drain region 30 and the gate insulating layer 60 in the surface area of the semiconductor substrate 10 in the field region 14. The field insulating layer 50 has, in its portion overlapping the gate electrode 40, a step 51 having a height Δ which makes the gate insulating layer 50 thinner than its remaining portion. A maximum film thickness (thickness from a bottom surface 54 (the same applies hereinafter)) t1 of a portion of the field insulating layer 50 between the gate insulating layer 60 and the step 51 is thinner than a maximum thickness t0 of the remaining portion thereof between the drain region 30 and the step 51 (t1<t0). In addition, the maximum film thickness t1 of the portion of the field insulating layer 50 between the gate insulating layer 60 and the step 51 is thicker than a film thickness t11 of the gate insulating layer 60 (t1>t11). Furthermore, the field insulating layer 50 has a flat portion 53 including a flat surface almost parallel with the front surface of the semiconductor substrate 10, in the portion between the gate insulating layer 60 and the step 51. The flat portion 53 extends in a range (a width L) from the step 51 to a position in a vicinity of the end portion 52 of the field insulating layer 50 on the side closer to the gate insulating layer 60. A film thickness t of the flat portion 53 at an arbitrary position in the range is expressed with t11<t (<t1)<t0. A silicon oxide film exemplifies the field insulating layer 50.

No specific restriction is imposed on the height Δ of the step 51 as long as the film thickness t of the flat portion 53 at an arbitrary position in the range from the step 51 to the position in the vicinity of the end portion 52 of the field insulating layer 50 on the side closer to the gate insulating layer 60 satisfies t11<t<t0, and as long as the film thickness t is so set that the below-described on-resistance canbe reduced. Nevertheless, it is desirable that the height Δ should be set in a way that the position of the top surface of the flat portion 53 is equal to or higher than the position of the top surface of the gate insulating layer 60. In addition, it is desirable that the height Δ should be set in a way that the position of the top surface of the flat portion 53 is equal to or higher than the middle between the elevation of the top surface of a portion of the field insulating layer 50 which overlaps no gate insulating electrode 40 and the elevation of the top surface of the gate insulating layer 60. That is because, if the film thickness of the flat portion 53 on the field insulating layer 50 is too thin, the breakdown voltage (BVds) is likely to be determined by an electric field generated in this part so that BVds cannot be increased.

FIG. 3 shows an example where the step 51 has a single tier. However, it is also possible to provide multiple tiers between the location of the step 51 and the location of the end portion 52 of the field insulating layer 50 on the side closer to the gate insulating layer 60, and to give the multiple tiers the same function as the step 51 has. In this case, the multiple tiers should be provided between the location of the step 51 and the location of the end portion 52 shown in FIG. 3 in a way that the top surface of the field insulating layer 50 comes closer to the semiconductor substrate 10 monotonously. Moreover, a gentle slope may be included instead. Such a configuration makes it possible to reduce the on-resistance while facilitating the step coverage of the gate electrode 40 on a step.

The gate electrode 40 covers a part of the gate insulating layer 60 and a part of the field insulating layer 50 (including the step 51). An end of the gate electrode 40 reaches a vicinity of the end portion of the gate insulating layer 60 on the side closer to the source region 20. The other end of the gate electrode 40 reaches a range located beyond the step 51 of the field insulating layer 50. A polysilicon film exemplifies the gate electrode 40. The gate electrode 40 is connected to an upper interconnection via a contact (not illustrated).

In the case of the foregoing embodiment, as shown in FIG. 3, the transistor having the field drain structure includes: the step 51 in the field insulating layer 50; and the gate electrode 40 formed to cover the step 51. In addition, the thinner range of the field insulating layer 50 is fully covered with the gate electrode 40, and the thicker range of the field insulating layer 50 is partially covered with the gate electrode 40. By forming the step 51 in the portion of the field insulating layer 50 which overlaps the gate electrode 40, the following effects are obtainable. (1) The portion of the field insulating layer 50 located under the end portion of the gate electrode 40 on the' side closer to the drain region 30 is thicker. This thickness makes it possible to attenuate the electric field, and accordingly makes it possible to increase the BVds. (2) The portion of the field insulating layer 50 located under the portion of the gate electrode 40 between the gate insulating layer 60 and the step 51 is thinner. This thinness makes it easier for the accumulation layer to be formed in the surface of the offset layer (field layer 14), and accordingly makes it possible to reduce the on-resistance. In sum, increase of the breakdown voltage (BVds) and reduction of the on-resistance can be achieved at the same time.

Next, descriptions will be provided for a method of manufacturing a semiconductor device according to the present embodiment. FIGS. 4 to 12 are cross-sectional views showing an example of the method of manufacturing a semiconductor device according to the present embodiment. Note that the method of manufacturing a semiconductor device according to the present embodiment is just an example and thus can be modified as appropriate within the scope of the present invention.

As shown in FIG. 4, an oxide film 60a is formed on a P type (P⁻) silicon substrate serving as the semiconductor substrate 10. Next, a photoresist film (not illustrated) having a pattern including an opening portion for forming the field region 14 is formed on the oxide film 60a. Thereafter, by using the photoresist film as a mask, N type impurities (exemplified by P (phosphorus) and As (arsenic)) are implanted into the semiconductor substrate 10 through the oxide film 60a located in the bottom portion of the opening portion. Thereby, an impurity implantation layer 14a is formed. Afterward, the photoresist film is removed. Thus, the oxide film 60a is exposed to the outside.

Subsequently, a nitride film 91 is formed on the oxide film 60a. Thereafter, a photoresist film (not illustrated) having a pattern including an opening for forming the field insulating layer 50 is formed on the nitride film 91. Afterward, by using the photoresist film as a mask, the nitride film 91 is etched through the opening. After that, the photoresist film is removed. Thus, an opening portion 91a for forming the field insulating layer 50 is formed in the nitride film 91.

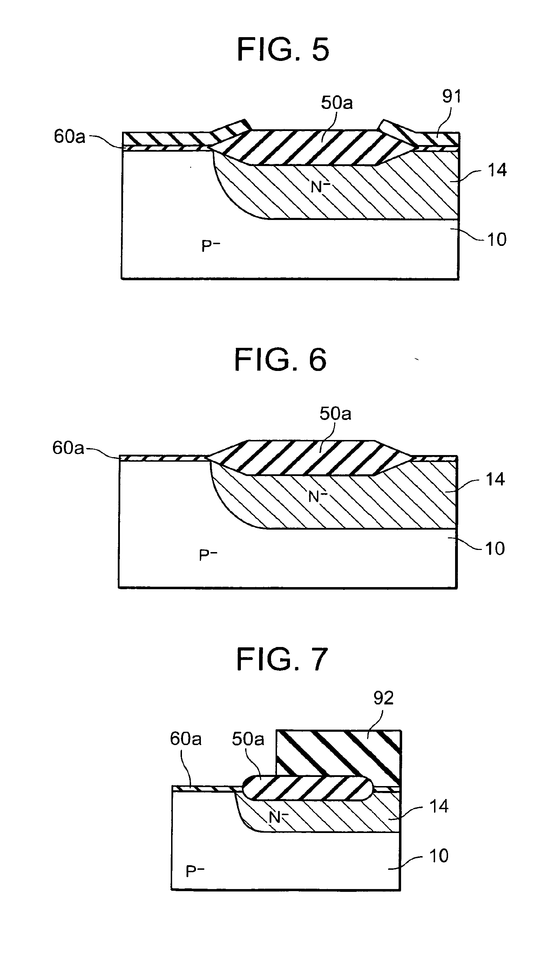

Thereafter, as shown in FIG. 5, the semiconductor substrate 10 is locally oxidized through the opening portion 91a formed in the nitride film 91, and the insulating layer 50a is thus formed. While this insulating layer 50a is formed, oxygen used for the oxidation process enters portions respectively below the end portions of the opening portion 91a. As a result, the thermal oxidation progresses in the semiconductor substrate 10 in a horizontal direction (in a direction in which the front surface of the semiconductor substrate 10 extends). Consequently, a pointed portion in which the insulating layer 50a becomes progressively thinner in thickness toward its end is formed in both ends of the insulating layer 50a. This pointed portion is termed as a bird's beak.

As the thermal oxidation for forming this insulating layer 50a progresses, the N type impurities in the impurity implantation layer 14a are diffused. Thus, the field region 14 in which the impurity concentration is lower is formed. At this time, parts of the N type impurities are also diffused into an area of the impurity implantation layer 14a which is located under each bird's beak, hence forming the field region 14 thereunder as well. Note that the impurity concentration in the area under each bird's beak is further lower because that area is located off, in the horizontal direction, an area right above which the N type impurities are implanted.

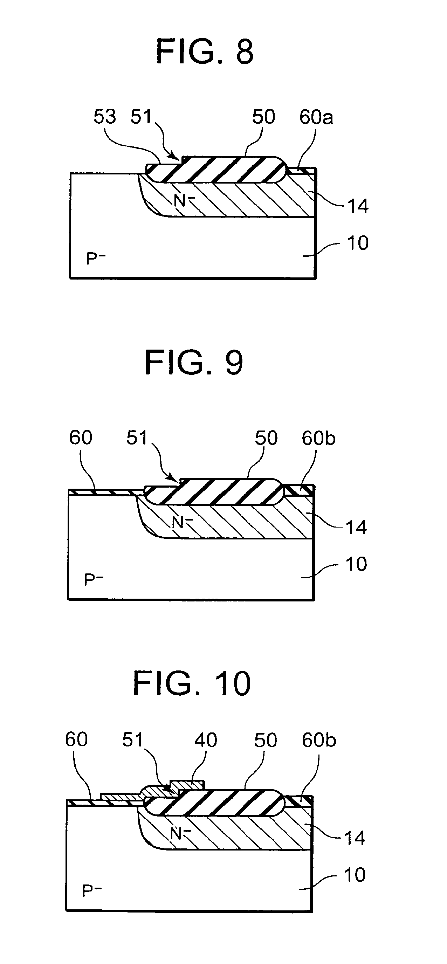

Next, as shown in FIG. 6, the nitride film 91 is removed by etching. Subsequently, as shown in FIG. 7, a photoresist film 92 having a pattern including an opening portion for forming the step 51 and the flat portion 53 in the insulating layer 50a is formed partially on the insulating layer 50a and the oxide film 60a. Afterward, as shown in FIG. 8, by using the photoresist film 92 as a mask, the insulating layer 50a is etched. Thereby, the field insulating layer 50 having the step 51 and the flat portion 53 in the respective predetermined locations is formed. Wet-etching by use of a hydrofluoric acid-based chemical liquid, for example, is one of the methods for implementing the etching herein. At this time, the oxide film 60a located on the front surface of a portion of the semiconductor substrate 10 and which is not covered with-the photoresist film 92 is removed together. After that, the photoresist film 92 is removed.

Subsequently, as shown in FIG. 9, by thermal oxidation, the gate insulating film 60 is formed on the front surface of a portion of the semiconductor substrate 10 from which the oxide film 60a has been removed. At this time, the gate insulating layer with a desired film thickness can be formed independently of the field insulating layer 50 depending on the conditions for forming the oxidation film. Thereafter, a polysilicon film (not illustrated) is formed. Afterward, a photoresist film (not illustrated) having a pattern for forming the gate electrode 40 is formed on the polysilicon film. Then, by using the photoresist film as a mask, the polysilicon film is etched. Thereby, as shown in FIG. 10, the gate electrode 40 is formed. Thereafter, the photoresist film is removed.

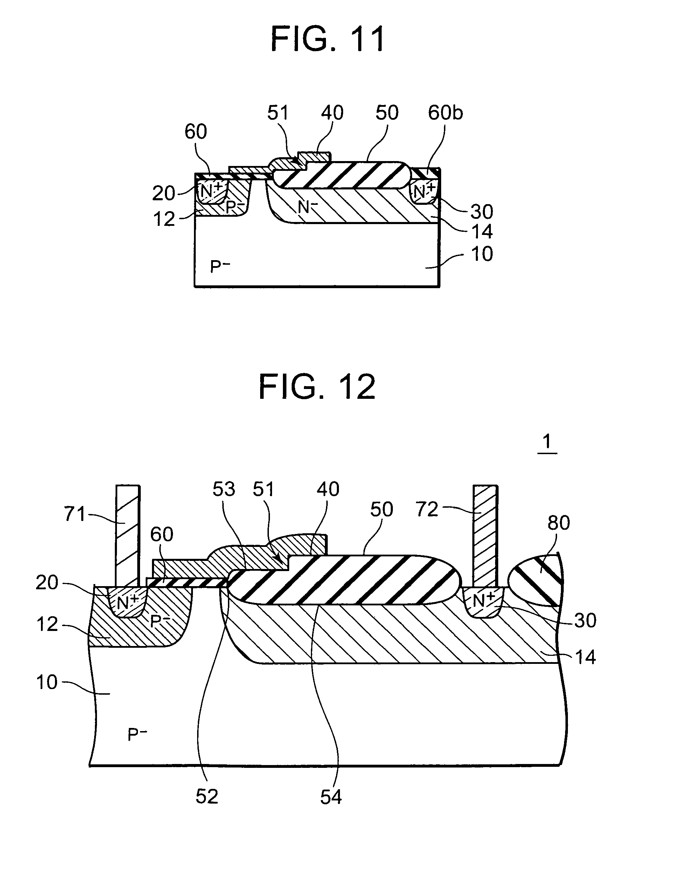

Afterward, as shown in FIG. 11, by using the gate electrode 40 as a mask, P type impurities (exemplified by B (boron)) are implanted into the semiconductor substrate 10. Thereby, the P well 12 is formed. Next, high concentration of N type impurities are implanted into a surface area of the P well. Thereby, the source region 20 is formed. Simultaneously, high concentration of N type impurities are implanted into a surface area of the field region 14. Thereby, the drain region 30 is formed.

After that, an interlayer insulation film (not illustrated) is formed to cover the entire resultant semiconductor substrate 10. Subsequently, as shown in FIG. 12, the contact 71, the contact 72, and the contact (not illustrated) are formed to be connected to the source region 20, the drain region 30, and the gate electrode 40, respectively, in a way to penetrate the interlayer dielectric.

By carrying out the method of manufacturing a semiconductor device according to the present embodiment which includes the above-described steps, it is possible to manufacture the semiconductor device (shown in FIG. 12 and FIG. 3) according to the present invention.

The semiconductor device manufactured by use of the method of manufacturing a semiconductor device according to the present embodiment includes the configuration shown in FIG. 3. For this reason, the thus-manufactured semiconductor device is capable of satisfying the requirement that the breakdown voltage (BVds) should be increased and the on-resistance should be reduced simultaneously.

### (Second Embodiment)

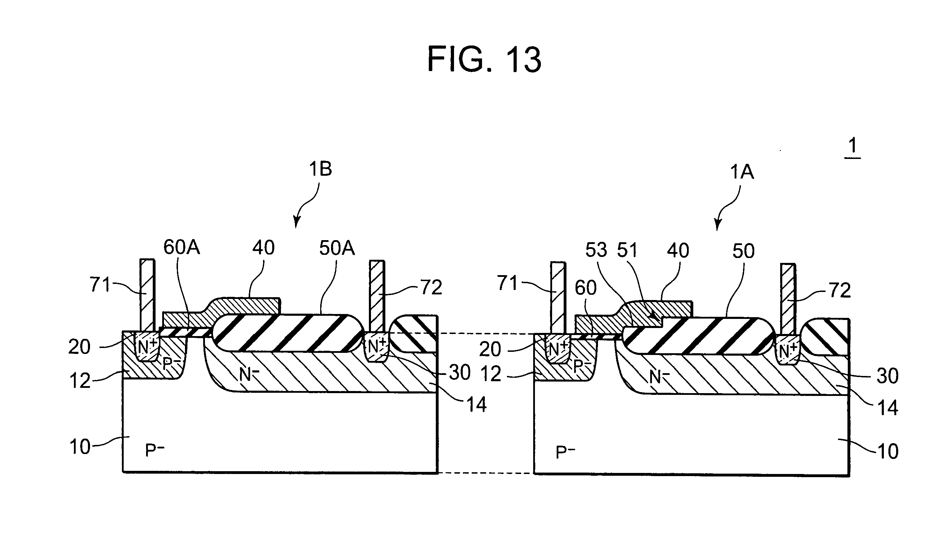

FIG. 13 is a cross-sectional view showing a configuration of a semiconductor device according to another embodiment. In the case of the present embodiment, N type (unidirectional) high breakdown-voltage transistors having their respective gate insulating layers whose film thicknesses are different from each other are formed on a single wafer. Specifically, this semiconductor device 1 includes transistors 1A and 1B having their respective gate insulating layers whose film thicknesses are different from each other. The transistor 1A is the same as the transistor according to the first embodiment. The transistor 1A includes a P well 12, a source region 20, a field region 14, a drain region 30, a gate insulating layer 60, a field insulating layer 50 and a gate electrode 40. The transistor 1B includes a well 12, a source region 20, a field region 14, a drain region 30, a gate insulating layer 60A, a field insulating layer 50A and a gate electrode 40.

The film thicknesses of the gate insulating layer 60A and the field insulating layer 50A of the transistor 1B are different from those of the transistor 1A. Specifically, the film thickness of the gate insulating layer 60A is thicker than that of the gate insulating layer 60. In addition, unlike the field insulating layer 50, the field insulating layer 50A does not include a step 51 or a flat portion 53. The rest of the configuration of the transistor 1B is the same as that of the transistor 1A (according to the first embodiment), and thus descriptions thereof will be omitted.

The film thickness of the field insulating layer 50 located under an end portion of the gate electrode 40 in the transistor 1A is equal to the film thickness of the field insulating layer 50A located under an end portion of the gate electrode 40 in the transistor 1A. For this reason, BVds of the transistor 1A and BVds of the transistor 1B can be equalized to each other.

In addition, the present embodiment makes it possible to form multiple types of high breakdown-voltage transistors, which are different in use application, in a single wafer. At that time, the present embodiment makes it possible to simultaneously increase the breakdown voltage (BVds) and reduce the on-resistance in at least one of the multiple transistors, as shown for the first embodiment.

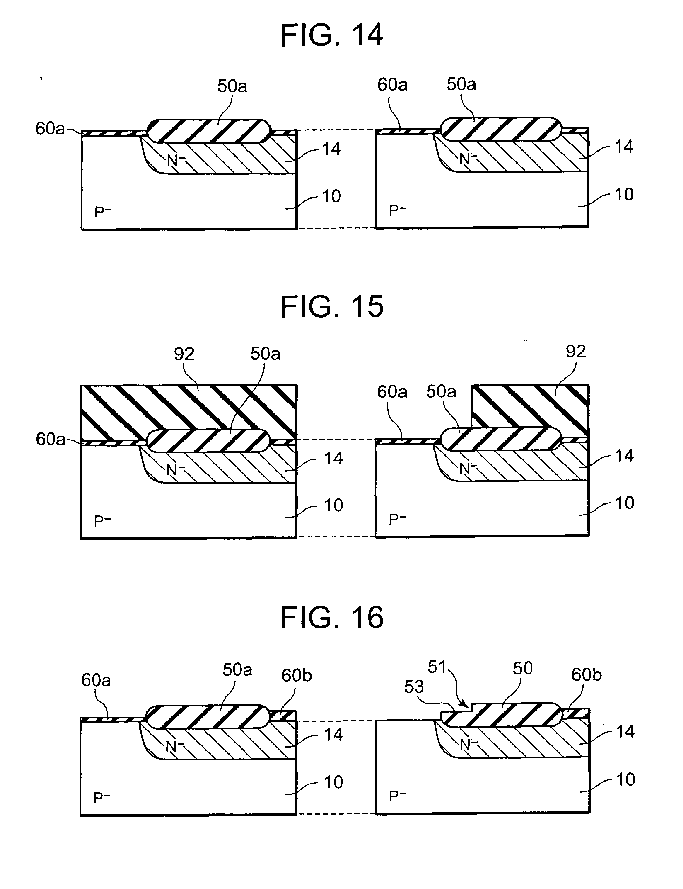

Next, descriptions will be provided for a method of manufacturing a semiconductor device according to the present embodiment. FIGS. 14 to 20 are cross-sectional views showing an example of the method of manufacturing a semiconductor device according to the present embodiment. The left half of each drawing shows the transistor 1B, and the right half of each drawing shows the transistor 1A. Note that the method of manufacturing a semiconductor device according to the present embodiment is just an example, and can be modified as appropriate within the scope of the present invention.

The initial steps are the same as the steps according to the first embodiment which are respectively shown in FIGS. 4 to 6, and thus descriptions thereof will be omitted. FIG. 14 shows the same condition as FIG. 6 shows. Subsequently, as shown in FIG. 15, in the transistor 1A, a photoresist film 92 having a pattern including an opening portion for forming the step 51 and the flat portion 53 in the field insulating layer 50 is partially formed on an insulating layer 50a and an oxide film 60a. On the other hand, at this time, in the transistor 1B, the photoresist film 92 is formed in a way to entirely cover the insulating layer 50a and the oxide film 60a.

Thereafter, as shown in FIG. 16, in the transistor 1A, by using the photoresist film 92 as a mask, the insulating layer 50a is etched. Thereby, the field insulating layer 50 having the step 51 and the flat portion 53 in its predetermined locations is formed. Wet-etching by use of a hydrofluoric acid-based chemical liquid, for example, is one of the methods for implementing the etching herein. At this time, the oxide film 60a which is located on the front surface of a portion of the semiconductor substrate 10 and which is not covered with the photoresist film 92 is removed together. On the other hand, at this time, in the transistor 1B, the insulating layer 50a and the oxide film 60a are not etched because the insulating layer 50a and the oxide film 60a are covered with the photoresist film 92 . This insulating layer 50a becomes the field insulating layer 50A. Afterward, the photoresist film 92 is removed.

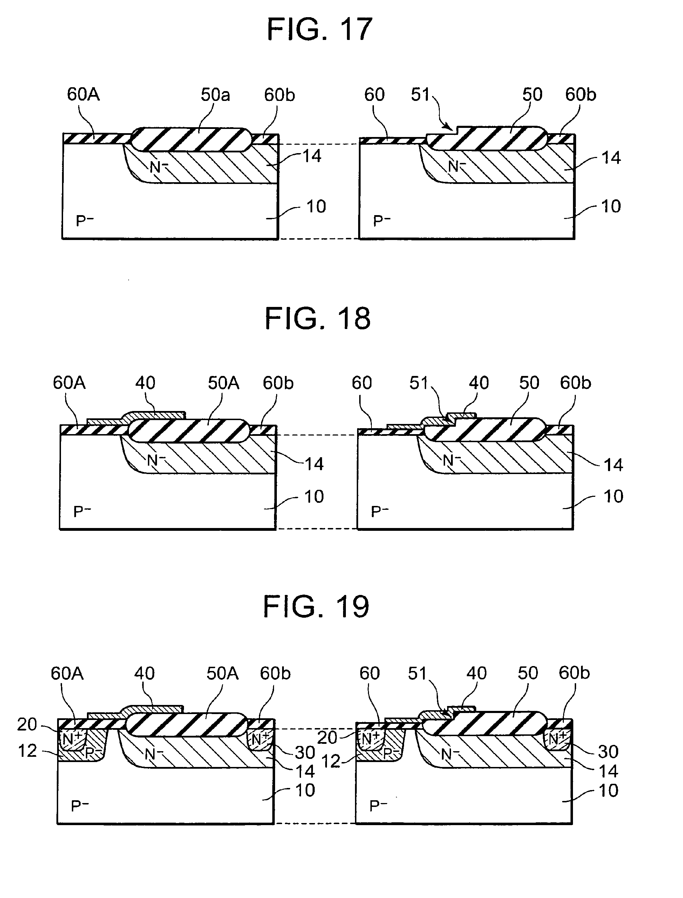

Subsequently, as shown in FIG. 17, in the transistor 1A, by thermal oxidation, the gate insulating layer 60 is formed on the front surface of a portion of the semiconductor substrate 10 from which the oxide film 60a has been removed. At this time, the gate insulating layer with a desired film thickness can be formed independently of the field insulating layer 50 depending on the conditions for forming the oxide film. On the other hand, at this time, in the transistor 1B, the film thickness of the oxide film 60a becomes thicker due to the thermal oxidation, and thus the oxidation film 60a becomes the gate insulating layer 60A. By this step, it is possible to make the gate insulating layer 60A in the transistor 1B become thicker in thickness, and concurrently to make the gate insulating layer 60 in the transistor 1A become thinner in thickness.

The subsequent steps shown in FIGS. 18 to 20 are the same as the steps shown in FIGS. 10 to 12 for the first embodiment, and thus descriptions thereof will be omitted.

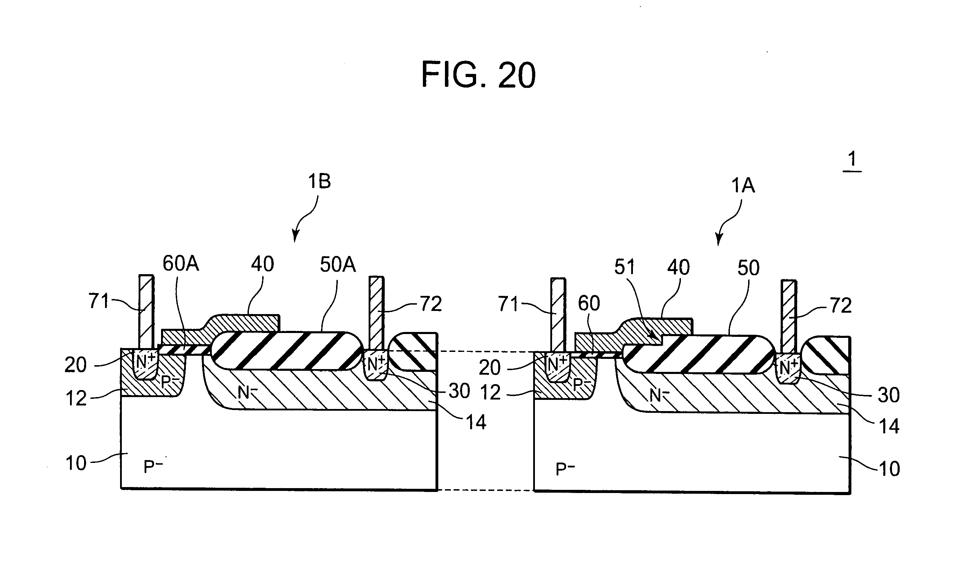

By carrying out the method of manufacturing a semiconductor device according to the present embodiment which includes the foregoing steps, it is possible to manufacture the semiconductor device (shown in FIGS. 20 and 13) according to the present invention.

The method of manufacturing a semiconductor device according to the present embodiment makes it possible to manufacture at least two types of high breakdown-voltage transistors having their respective gate insulating layers whose film thicknesses are different from each other, in a single wafer without increasingmanufacturing steps in number. At this time, the method according to the present embodiment enables at least one transistor to simultaneously increase the breakdown voltage (BVds) and reduce the on-resistance.

The foregoing descriptions have been provided for the embodiments by focusing on the N type (unidirectional) high breakdown-voltage transistor. Nevertheless, the present invention is not limited to these embodiments. The present invention can be similarly applied to a P type (unidirectional) high breakdown-voltage transistor, an N type (bidirectional) high breakdown-voltage transistor and a P type (bidirectional) high breakdown-voltage transistor as well. In the case of such application, the present invention is also capable to offering the same effects as the foregoing embodiments are capable of offering.

## Claims

1. A semiconductor device comprising:
a first region of a first conductivity type which is formed in a surface area of a semiconductor substrate;
a source region of a second conductivity type which is formed in a surface area of the first region;
a second region of the second conductivity type which is formed in a surface area of the semiconductor substrate;
a drain region of the second conductivity type which is formed in a surface area of the second region;
a gate insulating layer formed on a front surface of the semiconductor substrate between the source region and the second region;
a field insulating layer formed in a surface area of the semiconductor substrate between the drain region and the gate insulating layer; and
a gate electrode covering part of the gate insulating layer and part of the field insulating layer,
wherein the field insulating layer has, in its portion overlapping the gate electrode, such a step that a portion of the field insulating layer between the step and the gate insulating layer is thinner than the rest of the field insulating layer.

2. The semiconductor device according to claim 1, wherein
a maximum film thickness of the portion of the field insulating layer between the step and the gate insulating layer is thinner than a maximum film thickness of a portion of the field insulating layer between the step and the drain region.

3. The semiconductor device according to claim 2, wherein
the portion of the field insulating layer between the step and the gate insulating layer has a surface almost parallel to the front surface of the semiconductor substrate.

4. The semiconductor device according to claim 2, wherein
the maximum film thickness of the portion of the field insulating layer between the step and the gate insulating layer is thicker than a film thickness of the gate insulating layer.

5. A method of manufacturing a semiconductor device comprising the steps of:
forming an insulating layer on a front surface of a semiconductor substrate, a second region of a second conductivity type in a surface area of the semiconductor substrate, and a field insulating layer in a surface area of the second region;
forming a resist film having a pattern including an opening portion corresponding to a part of the field insulating layer;
removing an upper portion of a part of the field insulating layer by using the resist film as a mask;
forming a gate electrode in a way that a part of a gate insulating layer formed on the front surface of the semiconductor substrate and a part of the field insulating layer including a step are covered with the gate electrode;
forming a first region of a first conductivity type in a surface area of the semiconductor substrate; and
forming a source region of the second conductivity type in a surface area of the first region, and a drain region of the second conductivity type in a surface area of the second region.

6. A method for manufacturing a semiconductor device comprising the step of:
forming
a first insulating layer on a front surface of a first formation section of a semiconductor substrate, and a second insulating layer on a front surface of a second formation section of the semiconductor substrate,
a second region of a second conductivity type in a surface area of the first formation section, and a fourth region of the second conductivity type in a surface area of the second formation section, and
a first field insulating layer in a surface area of the second region, and a second field insulating layer in a surface area of the fourth region,
forming a step by removing a part of the first insulating layer and an upper portion of a part of the first field insulating layer in the first formation section;
forming, by thermal oxidation, a first gate insulating layer on a front surface of the resultant first formation section, and a second gate insulating layer on a front surface of the resultant second formation section, the second gate insulating layer being obtained by thickening the second insulating layer;
forming a first gate electrode in a way that a part of the first gate insulating layer and a part of the first field insulating layer including the step are covered with the first gate electrode, while forming a second gate electrode in a way that a part of the second gate insulating layer and a part of the second field insulating layer are covered with the second gate electrode;
forming a first region of a first conductivity type in a surface area of the consequent first formation section, and a third region of the first conductivity type in a surface area of the consequent second formation section; and
forming a first source region of the second conductivity type in a surface area of the first region, and a first drain region of the second conductivity type in a surface area of the second region, while forming a second source region of the second conductivity type in a surface area of the third region, and a second drain region of the second conductivity type in a surface area of the fourth region.
